(19) Europäisches Patentamt / European Patent Office / Office européen des brevets

(11) **EP 3 381 244 B1**

(12) **EUROPÄISCHE PATENTSCHRIFT**

(45) Veröffentlichungstag und Bekanntmachung des Hinweises auf die Patenterteilung:
**08.06.2022   Patentblatt 2022/23**

(21) Anmeldenummer: **15801421.7**

(22) Anmeldetag: **27.11.2015**

(51) Internationale Patentklassifikation (IPC):
**H01S 3/00** *(2006.01)*     **H01S 3/10** *(2006.01)*
**H01S 3/23** *(2006.01)*     **H05G 2/00** *(2006.01)*

(52) Gemeinsame Patentklassifikation (CPC):
**H05G 2/008; H01S 3/005; H01S 3/10023; H01S 3/2391;** H01S 3/0064; H01S 3/2316

(86) Internationale Anmeldenummer:
**PCT/EP2015/077873**

(87) Internationale Veröffentlichungsnummer:
**WO 2017/088929 (01.06.2017 Gazette 2017/22)**

(54) **TREIBERLASERANORDNUNG, EUV-STRAHLUNGSERZEUGUNGSVORRICHTUNG UND VERFAHREN ZUM VERSTÄRKEN VON LASERPULSEN**

DRIVER LASER ARRANGEMENT, EUV RADIATION GENERATING DEVICE AND METHOD FOR AMPLIFYING LASER PULSES

ENSEMBLE LASER EXCITATEUR, DISPOSITIF DE PRODUCTION DE RAYONNEMENT EUV ET PROCÉDÉ D'AMPLIFICATION D'IMPULSIONS LASER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**03.10.2018   Patentblatt 2018/40**

(73) Patentinhaber: **TRUMPF Lasersystems for Semiconductor Manufacturing GmbH 71254 Ditzingen (DE)**

(72) Erfinder: **WISSERT, Matthias 70176 Stuttgart (DE)**

(74) Vertreter: **Kohler Schmid Möbus Patentanwälte Partnerschaftsgesellschaft mbB Gropiusplatz 10 70563 Stuttgart (DE)**

(56) Entgegenhaltungen:
**WO-A1-2012/073087     WO-A1-2013/104947 US-A1- 2008 149 862**

• **None**

**Beschreibung**

Die vorliegende Erfindung betrifft eine Treiberlaseranordnung für eine EUV-Strahlungserzeugungsvorrichtung, umfassend: eine Strahlquelle, die ausgebildet ist, einen ersten Laserpuls mit einer ersten Wellenlänge und einen zweiten Laserpuls mit einer zweiten Wellenlänge zu erzeugen, sowie eine Verstärkeranordnung mit mindestens einem optischen Verstärker zur Verstärkung des ersten Laserpulses und des zweiten Laserpulses. Die Erfindung betrifft auch eine EUV-Strahlungserzeugungsvorrichtung mit einer solchen Treiberlaseranordnung sowie ein Verfahren zum Verstärken eines ersten Laserpulses mit einer ersten Wellenlänge und eines zweiten Laserpulses mit einer zweiten Wellenlänge in einer Treiberlaseranordnung für eine EUV-Strahlungserzeugungsvorrichtung.

US 2008/149862 A1 offenbart eine Treiberlaseranordnung für eine EUV-Strahlungserzeugungsvorrichtung, umfassend:eine Laserstrahlquelle die ausgebildet ist, einen ersten Vor-Puls mit einer ersten Wellenlänge und einen zweiten, zeitlich nachfolgenden HauptPuls mit einer zweiten Wellenlänge zu erzeugen, sowie eine Verstärkeranordnung mit mindestens einem optischen Verstärker zur Verstärkung des ersten Vor-Pulses und des zweiten Haupt-Pulses, eine Überlagerungseinrichtung zum Zusammenführen der Strahlwege der beiden Laserpulse vor der Verstärkeranordnung, so dass die beiden Laserpulse die Verstärkeranordnung im gleichen Strahlengang durchlaufen. Eine Treiberlaseranordnung für eine EUV-Lichtquelle ist ebenfalls aus der US 2006/0192152 A1 oder der US 2009/0095925 A1 bekannt geworden. Die Strahlquelle der Treiberlaseranordnung dient zur Erzeugung von so genannten Seed-Pulsen, die in dem bzw. in den optischen Verstärkern auf hohe Laserleistungen von mehreren kW, ggf. von 10 kW oder darüber verstärkt werden. Die von der Treiberlaseranordnung verstärkte Laserstrahlung wird über eine Strahlführungseinrichtung einer Fokussiereinrichtung zugeführt, welche die Laserstrahlung in einem Zielbereich fokussiert. In dem Zielbereich wird ein Target-Material bereitgestellt, weiches bei der Bestrahlung mit der Laserstrahlung in einen Plasma-Zustand übergeht und hierbei EUV-Strahlung emittiert.

Bei der weiter oben beschriebenen Treiberlaseranordnung wird typischer Weise von der Strahlquelle ein erster Laserpuls (Vor-Puls) und zeitlich nachfolgend ein zweiter Laserpuls (Haupt-Puls) erzeugt und auf den Zielbereich mit dem Target-Material fokussiert. Der erste Laserpuls soll dazu dienen, das Target-Material zu beeinflussen, beispielsweise dieses aufzuheizen, zu expandieren, zu vaporisieren, zu ionisieren und/oder um ein schwaches oder ggf. ein starkes Plasma zu erzeugen. Der zweite Laserpuls soll dazu dienen, den Hauptteil des von dem ersten Laserpuls beeinflussten Materials in den Plasmazustand überzuführen und hierbei EUVStrahlung zu erzeugen. Der erste Laserpuls weist typischer Weise eine deutlich geringere Laserleistung als der zweite Laserpuls auf. Bei der Treiberlaseranordnung der US 2009/0095925 A1 wird für den ersten Laserpuls und für den zweiten Laserpuls dieselbe Laserwellenlänge verwendet.

Es ist auch möglich, für den ersten Laserpuls und für den zweiten Laserpuls unterschiedliche Wellenlängen zu verwenden, wie dies in der WO 2011/162903 A1 beschrieben ist, in der ein Seed-Laser zur Erzeugung des ersten Laserpulses und ein weiterer Seed-Laser mit anderer Wellenlänge zur Erzeugung des zweiten Laserpulses verwendet wird. Die beiden Laserpulse mit unterschiedlichen Wellenlängen werden mittels eines Strahlkombinierers kombiniert, um entlang eines gemeinsamen Strahlwegs einen oder mehrere Verstärker sowie die auf die Treiberlaseranordnung folgende Strahlführungseinrichtung zu durchlaufen.

Bei der oben beschriebenen Treiberlaseranordnung kann eine Reflexion der verstärkten Laserstrahlung beispielsweise an dem Target-Material erfolgen, das z.B. in Form von Zinn-Tröpfchen vorliegen kann. Der an einem solchen Tröpfchen erzeugte Rückreflex läuft in den bzw. in die optischen Verstärker zurück und durchläuft das dort vorhandene Verstärkungsmedium, so dass auch der Rückreflex in dem bzw. in den optischen Verstärkern verstärkt wird. Auch ein schwacher Rückreflex ist ggf. ausreichend, um nach der Verstärkung in dem Verstärkungsmedium des/der optischen Verstärker eine Leistung zu erzeugen, die optische oder ggf. mechanische Komponenten in der Verstärkeranordnung oder im Strahlengang vor dem optischen Verstärker beschädigen kann.

Zur Unterdrückung von rückreflektierter Laserstrahlung ist es bekannt, so genannte optische Isolatoren einzusetzen, die nur in einer Richtung Laserstrahlung durchlassen und die aufgrund dieser Eigenschaft auch als optische Dioden bezeichnet werden. Derartige optische Isolatoren können beispielsweise zwischen einer Strahlquelle und einem optischen Verstärker oder auch zwischen zwei optischen Verstärkern angeordnet werden. Beispielsweise ist es aus der DE 41 27 407 A1 bekannt, jeweils eine optische Diode zwischen einem Injection-Seeding-Laser und einem Resonator sowie zwischen einem Resonator und einem Verstärker anzubringen.

Bei der oben beschriebenen Treiberlaseranordnung können bei der Verstärkung hohe Laserleistungen von 500 W und darüber, von 1 kW und darüber und sogar von 10 kW und mehr erzeugt werden. Bei derart hohen Laserleistungen besteht das Problem, dass die bei herkömmlichen optischen Isolatoren verwendeten optischen Bauteile ggf. starke thermisch bedingte Aberrationen, insbesondere Astigmatismus, hervorrufen und zudem ggf. durch die Laserstrahlung beschädigt werden können. Zudem besteht das Problem, dass optische Isolatoren in der Regel Laserstrahlung, die in die unerwünschte Richtung propagiert, nicht zu 100% unterdrücken können, so dass bei hohen Laserleistungen trotz der Verwendung von optischen Isolatoren der nicht unterdrückte Leistungsanteil so groß ist, dass ggf. trotz der Verwendung eines optischen Isolators zurücklaufende Laserstrahlung erzeugt wird. Erschwerend kommt bei der vorliegenden Anwendung hinzu, dass optische Dioden, welche auf dem Prinzip des Polarisators bzw. Phasenschiebers basieren, bauartbedingt nur Laserstrahlung mit einem bestimmten Phasensprung bzw. mit einer bestimmten Phasenverschiebung (bspw. 180°) unterdrücken können. Der Wert für diesen Phasensprung bzw. für diese Phasenverschiebung wird ggf. bei der Reflexion an einem Tröpfchen nicht eingehalten, so dass die an dem Tröpfchen reflektierte Laserstrahlung auch aus diesem Grund von der optischen Diode nicht vollständig unterdrückt werden kann.

Aus der EP 0 674 375 A2 ist es bekannt, schädliche Feedback-Reflexionen von einem Leistungs-Verstärker in einen Laser-Master-Oszillator zu eliminieren, indem eine nicht-reziproke (akusto-optische) Frequenzverschiebungseinrichtung zwischen dem Oszillator und dem Verstärker angeordnet wird, welche die Laserfrequenz um mehr als das Doppelte der Bandbereite des optischen Resonators des Laser-Oszillators verschiebt.

## Aufgabe der Erfindung

Der Erfindung liegt die Aufgabe zugrunde, eine Treiberlaseranordnung für eine EUV-Strahlungserzeugungsvorrichtung, eine EUV-Strahlungserzeugungsvorrichtung sowie ein Verfahren zum Verstärken eines ersten und eines zweiten Laserpulses bereitzustellen, bei denen ein ggf. rückreflektierter erster Laserpuls wirksam unterdrückt werden kann.

## Gegenstand der Erfindung

Diese Aufgabe wird gelöst durch eine Treiberlaseranordnung der eingangs genannten Art, bei der die Verstärkeranordnung mindestens ein wellenlängenselektives optisches Element aufweist, das ausgebildet ist, den ersten Laserpuls bei der ersten Wellenlänge stärker abzuschwächen als den zweiten Laserpuls bei der zweiten Wellenlänge.

Wie weiter oben beschrieben wurde, werden der erste Laserpuls (Vor-Puls) und der zweite Laserpuls (Haupt-Puls) in kurzer zeitlicher Abfolge nacheinander auf das Target-Material eingestrahlt. Die beiden Laserpulse durchlaufen die Verstärkeranordnung mit dem mindestens einen optischen Verstärker im gleichen Strahlengang, aber leicht zeitversetzt. Der erste Laserpuls sollte gegenüber dem zweiten Laserpuls eine geringere Leistung aufweisen.

Bei der hier beschriebenen Verwendung einer Verstärkeranordnung in einer Treiberlaseranordnung hat es sich als günstig erwiesen, wenn die (Gesamt-)Verstärkung der Verstärkeranordnung für den ersten Laserpuls gegenüber der (Gesamt-)Verstärkung für den zweiten Laserpuls reduziert ist. An Stelle einer Reduzierung der Leistung der den ersten Laserpuls erzeugenden Strahlquelle wird die Verstärkung des ersten Laserpulses in der Verstärkeranordnung gegenüber der Verstärkung des zweiten Laserpulses reduziert, indem das wellenlängenselektive optische Element den ersten Laserpuls mit der ersten Wellenlänge stärker abschwächt als den zweiten Laserpuls mit der zweiten Wellenlänge.

Dies ist günstig, da wie weiter oben dargestellt wurde, ein Teil der Leistung des ersten Laserpulses an dem Target-Material in den Strahlengang zurück reflektiert wird, der den oder die optische(n) Verstärker der Verstärkeranordnung durchläuft, von diesen ggf. auf eine zerstörerische Leistung verstärkt wird und in die Strahlquelle rückgekoppelt wird. Der Rückreflex bzw. der rückreflektierte Anteil der Laserstrahlung des ersten Laserpulses wird in den optischen Verstärkern mit der momentan verfügbaren Verstärkung verstärkt. Die Verstärkung der zurück laufenden Laserstrahlung ist insbesondere beim ersten Laserpuls problematisch, da aufgrund der geringen Leistung des ersten Laserpulses in dem Verstärkermedium des bzw. der einzelnen optischen Verstärker noch sehr viel "Leistung" bzw. eine hohe Besetzungsinversion vorhanden ist, die der Rückreflex des ersten Laserpulses beim Zurücklaufen durch den bzw. die optischen Verstärker nutzt und hierbei eine deutliche Verstärkung erfährt.

Durch das wellenlängenselektive optische Element wird ein wellenlängenselektiver Rückreflexschutz realisiert: Der rückreflektierte Anteil des ersten Laserpulses wird von dem wellenlängenselektiven optischen Element stärker abgeschwächt als der zweite Laserpuls bzw. dessen rückreflektierter Anteil. Die geringere Verstärkung der Verstärkeranordnung für den ersten Laserpuls in Vorwärtsrichtung kann bis zu einem gewissen Grad dadurch ausgeglichen werden, dass die Strahlquelle, die den ersten Laserpuls erzeugt, eine höhere Laserleistung erzeugt, d.h. dass eine höhere Laserleistung für den Seed-Puls der Strahlquelle gewählt wird, als sie ohne die Einbringung des wellenlängenselektiven optischen Elements in den Strahlengang der Verstärkeranordnung erforderlich wäre.

Die Anordnung von zwei oder mehr wellenlängenselektiven optischen Elementen an unterschiedlichen Positionen in der Verstärkeranordnung kann dazu dienen, eine Optimierung der Verstärkung für die jeweiligen Wellenlängen, insbesondere für die erste Wellenlänge, vorzunehmen. Dies ist insbesondere günstig, wenn die bzw. einzelne der optischen Verstärker in der Sättigung betrieben werden, d.h. eine nichtlineare Verstärkung aufweisen. Durch eine geeignete Festlegung der jeweiligen Abschwächung, die von den wellenlängenselektiven optischen Elementen an unterschiedlichen Positionen innerhalb der Verstärkeranordnung erzeugt wird, kann in diesem Fall die Verstärkeranordnung insgesamt hinsichtlich ihrer Verstärkung optimiert werden.

Um eine unterschiedliche Verstärkung des ersten Laserpulses und des zweiten Laserpulses in der Verstärkeranordnung zu erzeugen, kann es ggf. sinnvoll sein, zusätzlich zur Verwendung eines oder mehrerer wellenlängenselektiver optischer Elemente die Wellenlänge/Laserfrequenz des ersten und/oder des zweiten Laserpulses durchzustimmen bzw. zu verändern. Eine solche Frequenzverschiebung bzw. Durchstimmung der Wellenlänge kann in der Strahlquelle selbst oder in der Verstärkeranordnung vorgenommen werden, beispielsweise zwischen zwei optischen Verstärkern. Die Treiberlaseranordnung kann zu diesem Zweck mindestens eine Frequenzverschiebungseinrichtung zur Verschiebung der Laserfrequenz eines oder ggf. beider Laserpulse aufweisen. Bei der Frequenzverschiebungseinrichtung kann es sich beispielsweise um einen akustooptischen Modulator handeln. Die Durchstimmung der Laserfrequenz kann beispielsweise wie in der PCT/EP2014/064958 beschrieben erfolgen, welche durch Bezugnahme in ihrer Gesamtheit zum Inhalt dieser Anmeldung gemacht wird.

Durch die Frequenzverschiebung, d.h. durch die Veränderung der Wellenlänge eines oder beider Laserpulse, kann ebenfalls die Verstärkung der Verstärkeranordnung eingestellt werden: Wird die Laserfrequenz eines Laserpulses relativ zur Maximums-Frequenz verschoben, d.h. relativ zu derjenigen Frequenz bzw. Wellenlänge, bei der die wellenlängenabhängige Verstärkung eines jeweiligen optischen Verstärkers maximal ist, verringert sich die Verstärkung des jeweiligen Laserpulses. Eine solche Frequenzverschiebung, beispielswese wie sie in der PCT/EP2014/064958 beschrieben ist, kann mit der hier beschriebenen Abschwächung durch das bzw. durch die wellenlängenselektiven optischen Elemente vorteilhaft kombiniert werden, um die Verstärkeranordnung insgesamt zu optimieren. Insbesondere kann die Frequenzverschiebung auch während des Betriebs der Treiberlaseranordnung eingestellt bzw. variiert werden, so dass durch die Frequenzverschiebung eine Feinabstimmung der von der Verstärkeranordnung erzeugten Verstärkung vorgenommen werden kann.

Bei einer Ausführungsform ist die Abschwächung des ersten Laserpulses bei der ersten Wellenlänge durch das mindestens eine wellenlängenselektive optische Element bei der Propagation durch die Verstärkeranordnung um mehr als 10 % größer als die Abschwächung des zweiten Laserpulses bei der zweiten Wellenlänge bei der Propagation durch die Verstärkeranordnung. Sind in der Verstärkeranordnung zwei oder mehr wellenlängenselektive optische Elemente angeordnet, so bezieht sich die Abschwächung von mehr als 10% auf die Abschwächung, die durch die Gesamtheit der wellenlängenselektiven optischen Elemente in der Verstärkeranordnung (d.h. in Summe) erzeugt wird. Idealer Weise wird der zweite Laserpuls bei der zweiten Wellenlänge durch das mindestens eine wellenlängenselektive optische Element nicht bzw. nur so wenig wie möglich abgeschwächt. Mittels eines wellenlängenselektiven optischen Elements eine Abschwächung des zweiten Laserpulses von (fast) 0 % zu erreichen ist jedoch typischer Weise nur schwer möglich.

Bei einer Ausführungsform ist das wellenlängenselektive optische Element ein reflektierendes optisches Element, dessen Reflektivität bei der ersten Wellenlänge kleiner ist als dessen Reflektivität bei der zweiten Wellenlänge. Die Verwendung eines reflektierenden optischen Elements als wellenlängenselektives Element ist günstig, da die Abschwächung der Laserleistung bei einem solchen Element grundsätzlich linear ist, d.h. der reflektierte Strahlungsanteil ist typischer Weise unabhängig von der auftreffenden Laserleistung, d.h. unabhängig von der Stärke der auftreffenden Laserleistung wird ein bestimmter Anteil der auftreffenden Laserstrahlung reflektiert (Reflexion von x %).

Bei dem reflektierenden optischen Element kann es sich beispielsweise um einen (ggf. teiltransmissiven) Spiegel handeln, der bei der ersten Wellenlänge eine kleinere Reflektivität aufweist als bei der zweiten Wellenlänge. Der Spiegel kann bereits in der Treiberlaseranordnung vorgesehen sein, z.B. um eine Faltung des Strahlengangs zu bewirken, oder in einem optischen Verstärker bzw. in einem Resonator eines optischen Verstärkers angeordnet sein. Durch die Ausbildung eines solchen Spiegels als wellenlängenselektives optisches Element, z.B. durch Aufbringen einer wellenlängenselektiven reflektierenden Beschichtung, ist es nicht erforderlich, ein zusätzliches wellenlängenselektives optisches Element in der Treiberlaseranordnung vorzusehen.

Die Reflektivität eines solchen Spiegels bzw. eines solchen reflektierenden optischen Elements für die zweite Wellenlänge sollte möglichst groß sein, während die Reflektivität für die erste Wellenlänge gegenüber der maximal möglichen Reflektivität um einen gewünschten Betrag reduziert ist, so dass die Absorption um einen gewünschten Betrag erhöht ist. Um eine gewünschte Abschwächung des ersten Laserpulses zu erzeugen, kann eine Mehrzahl bzw. prinzipiell eine beliebige Anzahl von Spiegeln mit einer vorgegebenen Absorption bzw. Reflexionsunterdrückung für die erste Wellenlänge im Strahlengang der Verstärkeranordnung vorgesehen sein. Die Verwendung von mehreren Spiegeln zur Abschwächung des ersten Laserpulses kann insbesondere günstig sein, um zu vermeiden, dass an den einzelnen Spiegeln die Absorption für die erste Wellenlänge so groß ist, dass diese ggf. degradieren.

Bei einer Weiterbildung ist das wellenlängenselektive reflektive optische Element ein Umlenkspiegel der Verstärkeranordnung. Es hat sich als günstig erwiesen, einen Umlenkspiegel als wellenlängenselektives optisches Element zu verwenden, da Umlenkspiegel typischer Weise ohnehin im Strahlengang der Verstärkeranordnung benötigt werden. Es versteht sich aber, dass es sich bei dem wellenlängenselektiven optischen Element an Stelle eines Umlenkspiegels bzw. eines Faltungsspiegels um eine andere Art von reflektierendem optischen Element handeln kann.

Bei einer Weiterbildung weist das wellenlängenselektive reflektive optische Element bei der ersten Wellenlänge eine Reflektivität von weniger als 90 % auf. Die Leistung des ersten Laserpulses wird auf diese Weise um einen Anteil von 100 % - 10 % reduziert, so dass nur ein entsprechender Anteil von 90 % oder weniger in ggf. nachfolgenden Verstärkern der Verstärkeranordnung verstärkt wird und somit nur ein entsprechender Anteil der rückreflektierten Laserstrahlung in dem bzw. in den im Strahlweg vorausgehenden Verstärker(n) der Verstärkeranordnung verstärkt wird.

Bei einer weiteren Ausführungsform ist das wellenlängenselektive optische Element ein transmissives optisches Element, dessen Transmission bei der zweiten Wellenlänge größer ist als bei der ersten Wellenlänge. Alternativ oder zusätzlich zu einem wellenlängenselektiven reflektierenden optischen Element kann ggf. auch ein wellenlängenselektives transmissives optisches Element in den Strahlengang der Verstärkeranordnung eingebracht werden, um die Verstärkung des ersten Laserpulses zu reduzieren und auf diese Weise den Schutz vor Rückreflexen zu erhöhen. Das wellenlängenselektive transmissive optische Element weist zu diesem Zweck eine größere Absorption (in %) für die erste Wellenlänge als für die zweite Wellenlänge auf. Bei dem transmissiven wellenlängenselektiven optischen Element kann es sich beispielsweise um ein zusätzliches optisches Element in Form einer planparallelen Platte handeln, welche in den Strahlengang der Verstärkeranordnung eingebracht ist und auf welcher eine wellenlängenselektive Beschichtung aufgebracht ist. Bei dem wellenlängenselektiven optischen Element kann es sich auch um ein ohnehin in der Verstärkeranordnung vorhandenes transmissives optisches Element handeln, beispielsweise um ein Eintrittsfenster oder ein Austrittsfenster eines optischen Verstärkers, z.B. in Form einer planparallelen Platte. Derartige Fenster werden typischer Weise verwendet, um gasförmige Verstärkermedium in dem jeweiligen optischen Verstärker zu halten.

Bei einer vorteilhaften Ausführungsform weist das wellenlängenselektive optische Element eine wellenlängenselektive Beschichtung auf. Die Verwendung einer wellenlängenselektiven Beschichtung hat sich sowohl bei einem reflektierenden als auch bei einem transmittierenden wellenlängenselektiven optischen Element als günstig erwiesen, da sich mit einer solchen Beschichtung ein ausreichender Unterschied im Absorptionsgrad zwischen der ersten und der zweiten Wellenlänge erzeugen lässt. Dies trifft insbesondere auch für den Fall zu, dass sich die erste Wellenlänge und die zweite Wellenlänge nur geringfügig voneinander unterscheiden.

Bei einer weiteren Ausführungsform ist die Strahlquelle ausgebildet, den ersten Laserpuls bei einer ersten Wellenlänge zu erzeugen, die um 0,5 $\mu$m oder weniger von der zweiten Wellenlänge des zweiten Laserpulses abweicht. Typischer Weise sind in der Strahlquelle zwei Laserquellen vorgesehen, die Laserstrahlung bei den beiden unterschiedlichen Laserwellenlängen erzeugen. Sowohl der erste Laserpuls als auch der zweite Laserpuls können z.B. von $CO_2$-Laserquellen erzeugt werden. Zur Erzeugung der beiden Laserpulse können in diesem Fall ggf. unterschiedliche Linien im Absorptionsspektrum eines $CO_2$-Lasergases verwendet bzw. angeregt werden, beispielsweise eine Linie bei einer Wellenlänge von 10,6 $\mu$m oder eine Linie mit einer Wellenlänge im Bereich zwischen 10,1 $\mu$m und 10,35 $\mu$m. In diesem Fall kann beispielsweise eine erste $CO_2$-Laserquelle den ersten Laserpuls mit einer Wellenlänge im oben angegebenen Bereich zwischen 10,1 $\mu$m und 10,35 $\mu$m erzeugen und eine zweite $CO_2$-Laserquelle kann den zweiten Laserpuls mit einer Wellenlänge von 10,6 $\mu$m erzeugen. Gegebenenfalls kann die Strahlquelle eine einzige $CO_2$-Laserquelle aufweisen und die Wellenlänge der austretenden Laserstrahlung durchstimmen bzw. zwischen der ersten Wellenlänge und der zweiten Wellenlänge umschalten.

Bei einer weiteren Ausführungsform ist die Treiberlaseranordnung ausgebildet, den ersten Laserpuls mit der ersten Wellenlänge bei der Propagation durch die Verstärkeranordnung in einer ersten Propagationsrichtung, die von der Strahlquelle ausgeht, mit einer größeren leistungsabhängigen Verstärkung zu verstärken als in einer zweiten, der ersten entgegen gesetzten Propagationsrichtung. Da nur der Rückreflex des ersten Laserpulses unterdrückt werden soll, ist es grundsätzlich günstig, wenn der erste Laserpuls in Vorwärtsrichtung, d.h. in der ersten Propagationsrichtung, eine größere Verstärkung erfährt als in der zweiten Propagationsrichtung (Rückwärtsrichtung). Eine solche unterschiedliche Verstärkung in Vorwärts- und Rückwärtsrichtung in der Verstärkeranordnung lässt sich realisieren, weil die Unterdrückung bzw. die Abschwächung der Leistung mittels des wellenlängenselektiven optischen Elements grundsätzlich linear ist (Reflexion bzw. Transmission von x % unabhängig von der Laserleistung), während die Verstärkung in dem bzw. in den optischen Verstärkern ggf. nichtlinear erfolgt, d.h. von der Stärke der Laserleistung abhängig ist. Letzteres ist insbesondere der Fall, wenn ein optischer Verstärker im Sättigungszustand betrieben wird: Im Sättigungsbetrieb des optischen Verstärkers ist die Leistung der verstärkten Laserstrahlung nach oben begrenzt, d.h. die Verstärkung nimmt mit zunehmender eingekoppelter Laserleistung ab. Daher kann durch eine geeignete Positionierung des bzw. der wellenlängenselektiven optischen Elemente im Strahlengang vor bzw. nach dem bzw. den optischen Verstärkern mit einer nichtlinearen Verstärkung eine Optimierung der Verstärkung des ersten Laserpulses in Vorwärtsrichtung gegenüber der Unterdrückung des ersten Laserpulses in Rückwärtsrichtung erfolgen.

Hierbei ist zu beachten, dass in der Verstärkeranordnung sowohl an dem der Strahlquelle abgewandten Ende (aufgrund des in Vorwärtsrichtung propagierenden ersten Laserpulses) als auch an dem der Strahlquelle zugewandten Ende (aufgrund des in Rückwärtsrichtung laufenden reflektierten ersten Laserpulses) besonders hohe Leistungen auftreten, so dass die Absorption bzw. die Unterdrückung eines dort angeordneten wellenlängenselektiven optischen Elements nicht zu groß gewählt werden sollte, um eine Degradation des wellenlängenselektiven optischen Elements durch die Laserstrahlung zu vermeiden. Obwohl die Verstärkung in dem bzw. in den optischen Verstärkern für den ersten Laserpuls mit geringerer Laserleistung typischer Weise im Wesentlichen im linearen Verstärkungsbereich erfolgt, besteht hinsichtlich der unterschiedlichen Verstärkung ein Optimierungspotential.

Unter dem Begriff "Verstärkung" eines optischen Verstärkers wird im Sinne dieser Anmeldung die so genannte Kleinsignalverstärkung, genauer gesagt der Verstärkungskoeffizient der Kleinsignalverstärkung, verstanden. Bei der Kleinsignalverstärkung werden keine Sättigungseffekte berücksichtigt. Optische Verstärker weisen eine frequenzabhängige Kleinsignalverstärkung bzw. ein frequenzabhängiges Verstärkungsprofil auf, das beispielsweise bei einem $CO_2$-Gaslaser bzw. Verstärker im Wesentlichen einem Lorentz-Profil entsprechen kann. Das Verstärkungsprofil weist bei einer Maximums-Frequenz $f_M$ ein Maximum $V_{MAX}$ der (Kleinsignal-)Verstärkung auf. Für die (nicht normierte) maximale Verstärkung $V_{MAX}$, d.h. für den Verstärkungskoeffizienten der Kleinsignalverstärkung, gilt gemäß der Lasertheorie folgendes:

$$V_{MAX} = c^2 \, / \, (8 \, \pi \, f_M^2 \, \Delta B) \, (N_2 - N_1) \, 1/\tau_{sp} \, ,$$

wobei $\Delta B$ die Halbwertsbreite bzw. die Verstärkerbandbreite des frequenzabhängigen Verstärkerprofils, $N_2$ bzw. $N_1$ die Besetzungsdichte des oberen bzw. unteren Energieniveaus und $\tau_{sp}$ die mittlere Lebensdauer im oberen Energieniveau bezeichnen. Die (Kleinsignal-)Verstärkung $V_{MAX}$ hat die Einheit 1/Länge, z.B. cm$^{-1}$. Die Verstärkeranordnung weist typischer Weise mehrere in Reihe geschaltete Verstärker auf, die für den ersten Laserpuls (Vor-Puls) und für den zweiten Laserpuls (Haupt-Puls) eine bestimmte Inversion bereithalten, so dass für die erste bzw. die zweite Wellenlänge eine bestimmte (maximale) Verstärkung für jeden der beiden Laserpulse verfügbar ist.

Bei einer weiteren Ausführungsform ist das wellenlängenselektive optische Element in der ersten Propagationsrichtung vor oder in mindestens einem optischen Verstärker angeordnet, welcher den ersten Laserpuls mit einer kleineren als einer maximalen leistungsabhängigen Verstärkung verstärkt, d.h. die Verstärkung ist geringer als die maximale (lineare) Verstärkung $V_{MAX}$. Dies ist typischer Weise der Fall, wenn in dem optischen Verstärker Sättigungseffekte auftreten. In diesem Fall ist es günstig, wenn das wellenlängenselektive optische Element im Strahlengang vor oder ggf. in dem optischen Verstärker angeordnet ist, da in diesem Fall eine geringere Abschwächung der Laserleistung in Vorwärtsrichtung als in Rückwärtsrichtung erfolgt, da die Leistung des rückreflektierten ersten Laserpulses so gering ist, dass dieser in Rückwärtsrichtung typischer Weise nicht in der Sättigung betrieben wird.

Die Erfindung betrifft weiterhin eine EUV-Strahlungserzeugungsvorrichtung, umfassend: eine Treiberlaseranordnung, umfassend: eine Strahlquelle, die ausgebildet ist, einen ersten Laserpuls mit einer ersten Wellenlänge und einen zweiten Laserpuls mit einer zweiten Wellenlänge zu erzeugen, sowie eine Verstärkeranordnung mit mindestens einem optischen Verstärker zur Verstärkung des ersten Laserpulses und des zweiten Laserpulses, eine Vakuum-Kammer, in der ein Target-Material an einer Zielposition anordenbar ist, sowie eine Strahlführungseinrichtung zur Führung des ersten Laserpulses und des zweiten Laserpulses von der Treiberlasereinrichtung in Richtung auf die Zielposition, sowie mindestens ein wellenlängenselektives optisches Element, das ausgebildet ist, den ersten Laserpuls bei der ersten Wellenlänge stärker abzuschwächen als den zweiten Laserpuls bei der zweiten Wellenlänge. Wie weiter oben beschrieben wurde, wird typischer Weise ein Vor-Puls (erster Laserpuls) mit geringerer Laserleistung und zeitlich kurz danach ein Haupt-Puls (zweiter Laserpuls) mit größerer Laserleistung zu einem Target-Material beispielsweise in Form von Zinn-Tröpfchen geführt, um dieses in einen Plasma-Zustand überzuführen. Wie ebenfalls weiter oben beschrieben wurde, besteht insbesondere beim ersten Laserpuls das Problem, dass ein an dem Target-Material reflektierter Strahlungsanteil in der Verstärkeranordnung der Treiberlasereinrichtung verstärkt wird und im Strahlengang angeordnete optische Elemente beschädigen kann. Diese Gefahr kann durch das mindestens eine wellenlängenselektive optische Element reduziert werden. Das mindestens eine wellenlängenselektive optische Element ist in der Verstärkeranordnung, oder der Strahlführungseinrichtung angeordnet.

Die Erfindung betrifft auch ein Verfahren der eingangs genannten Art, umfassend: Verstärken des ersten Laserpulses mit der ersten Wellenlänge und des zweiten Laserpulses mit der zweiten Wellenlänge in mindestens einem optischen Verstärker einer Verstärkeranordnung der Treiberlaseranordnung, wobei der erste Laserpuls an mindestens einem wellenlängenselektiven optischen Element stärker abgeschwächt wird als der zweite Laserpuls. Wie weiter oben beschrieben wurde, erfolgt die Abschwächung bevorzugt durch mindestens ein wellenselektives optisches Element mit einer jeweils unterschiedlichen Reflektivität oder Transmission bei den beiden unterschiedlichen Wellenlängen.

Bei einer Variante wird der erste Laserpuls bei der ersten Wellenlänge an dem mindestens einen wellenlängenselektiven optischen Element um mehr als 10 % stärker abgeschwächt als der zweite Laserpuls bei der zweiten Wellenlänge. Ein solcher Unterschied in der Abschwächung kann beispielsweise durch eine um mindestens 10 % unterschiedliche Reflektivität oder durch eine um mindestens 10 % unterschiedliche Transmission des bzw. der wellenlängenselektiven optischen Elemente bei den beiden Wellenlängen erzeugt werden.

Bei einer weiteren Variante wird der erste Laserpuls mit der ersten Wellenlänge bei der Propagation durch die Verstärkeranordnung in einer ersten Propagationsrichtung, die von einer Strahlquelle der Verstärkeranordnung ausgeht, mit einer größeren leistungsabhängigen Verstärkung verstärkt als in einer zweiten, der ersten entgegen gesetzten Propagationsrichtung. Wie weiter oben beschrieben wurde, soll der Rückreflex des ersten Laserpulses wirksam unterdrückt werden, die Abschwächung des in Vorwärtsrichtung propagierenden Laserpulses soll hingegen möglichst nicht zu groß ausfallen. Wie weiter oben beschrieben wurde, kann dies durch eine geeignete Positionierung des wellenlängenselektiven optischen Elements im Strahlengang der Verstärkeranordnung erreicht werden.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

Fig. 1a   eine schematische Darstellung einer EUV-Strahlungserzeugungsvorrichtung mit einer Treiberlaseranordnung, welche eine Verstärkeranordnung mit zwei reflektierenden wellenlängenselektiven optischen Elementen umfasst,

Fig. 1b   einen optischen Verstärker der Verstärkeranordnung von Fig. 1a, in dem ein wellenlängenselektives optisches Element angeordnet ist, sowie

Fig. 2   eine schematische Darstellung einer EUV-Strahlungserzeugungsvorrichtung analog zu Fig. 1a, welche eine Verstärkeranordnung mit einem transmissiven wellenlängenselektiven optischen Element aufweist.

In der folgenden Beschreibung der Zeichnungen werden für gleiche bzw. funktionsgleiche Bauteile identische Bezugszeichen verwendet.

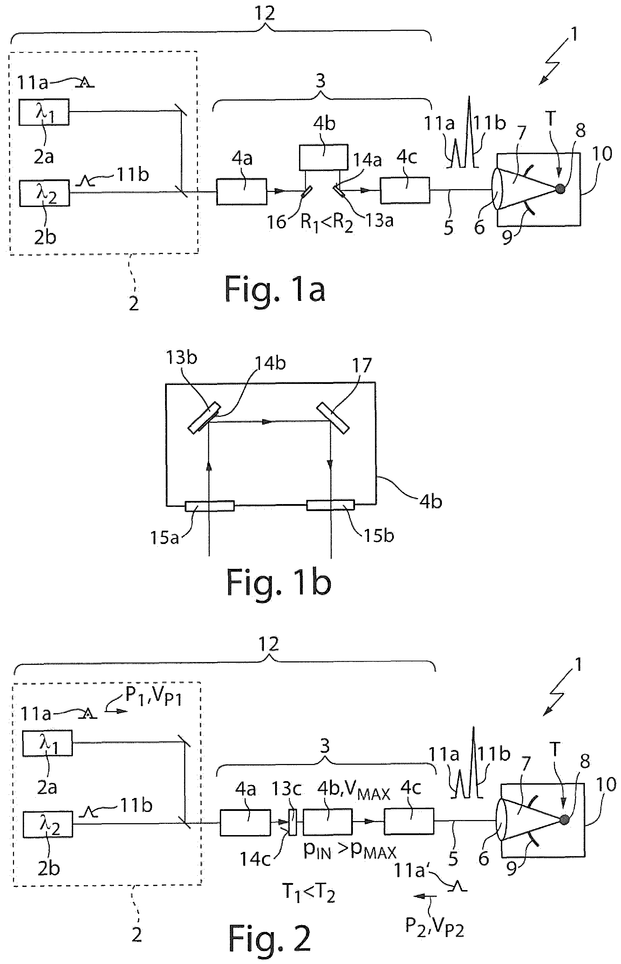

Fig. 1a zeigt stark schematisch eine EUV-Strahlungserzeugungsvorrichtung 1, welche eine Strahlquelle 2, eine Verstärkeranordnung 3 mit drei optischen Verstärkern 4a, 4b, 4c bzw. Verstärkerstufen, eine nicht näher dargestellte Strahlführungseinrichtung 5 sowie eine Fokussierlinse 6 aufweist. Die Fokussierlinse 6 dient dazu, einen von der Strahlquelle 2 erzeugten und von der Verstärkeranordnung 3 verstärkten ersten und zweiten Laserpuls 11a, 11b an einem Zielbereich bzw. einer Zielposition T zu fokussieren, an dem ein Target-Material 8 eingebracht ist. Das Target-Material 8 geht bei der Bestrahlung mit dem ersten und zweiten Laserpuls 11a, 11b in einen Plasma-Zustand über und emittiert hierbei EUV-Strahlung, die mittels eines Kollektorspiegels 9 fokussiert wird.

Bei dem in Fig. 1a gezeigten Beispiel weist der Kollektorspiegel 9 eine Öffnung zum Durchtritt der ersten und zweiten Laserpulse 11a, 11b auf und die Fokussierlinse 6 trennt eine Vakuum-Kammer 10, in welcher das Target-Material 8 angeordnet ist, von der Strahlführungseinrichtung 5. Die Strahlquelle 2 weist im gezeigten Beispiel eine erste und eine zweite Laserquelle 2a, 2b in Form von $CO_2$-Lasern auf, die den ersten Laserpuls 11a (Vor-Puls) und den zweiten Laserpuls 11b (Haupt-Puls) in kurzer zeitlicher Folge erzeugen, um diese gemeinsam, d.h. in einem gemeinsamen Strahlengang, in der Verstärkeranordnung 3 zu verstärken und auf das Target-Material 8 bzw. in den Bereich der Zielposition T zu fokussieren. Die Strahlquelle 2 bildet gemeinsam mit der Verstärkeranordnung 3 eine Treiberlaseranordnung 12 der EUV-Strahlungserzeugungsvorrichtung 1.

Die erste Laserquelle 2a dient im gezeigten Beispiel zur Erzeugung des ersten Laserpulses 11a bei einer ersten Wellenlänge $\lambda_1$ von 10,6 $\mu$m und die zweite Laserquelle 2b dient zur Erzeugung des zweiten Laserpulses 11b bei einer zweiten, von der ersten verschiedenen Wellenlänge $\lambda_2$, die beispielsweise zwischen 10,1 $\mu$m und 10,35 $\mu$m liegen kann (oder umgekehrt). Die beiden Wellenlängen $\lambda_1$, $\lambda_2$ unterscheiden sich im gezeigten Beispiel um nicht mehr als 0,5 $\mu$m. Die Strahlwege der beiden Laserquellen 2a, 2b werden vor der Verstärkeranordnung 3 zusammengeführt bzw. überlagert. Zu diesem Zweck kann eine (passive) Überlagerungseinrichtung, z.B. ein teildurchlässiger Spiegel, verwendet werden, wie dies in Fig. 1a dargestellt ist.

Wie in Fig. 1a anhand der Pulshöhen zu erkennen ist, werden die beiden Laserpulse 11a, 11b von der Strahlquelle 2 mit ungefähr gleicher Leistung erzeugt, aber in der Verstärkeranordnung 3 unterschiedlich stark verstärkt, so dass der verstärkte erste Laserpuls 11a am Ausgang der Verstärkeranordnung 3 eine geringere Laserleistung aufweist als der verstärkte zweite Laserpuls 11b. Die Verstärkung der Verstärkeranordnung 3 für den ersten Laserpuls 11a kann beispielsweise bei weniger als 90 %, ggf. bei weniger als 70 %, ggf. sogar bei weniger als ca. 50 % der Verstärkung der Verstärkeranordnung 3 für den zweiten Laserpuls 11b liegen. Dies ist vorteilhaft, da der erste Laserpuls 11a mit einer geringeren Leistung auf das Target-Material 8 treffen soll als der zweite Laserpuls 11b.

Die unterschiedliche Verstärkung der beiden Laserpulse 11a, 11b in der Verstärkeranordnung 3 wird dadurch erreicht, dass in der Verstärkeranordnung 3 ein erstes wellenlängenselektives optisches Element in Form eines ersten wellenlängenselektiven Spiegels 13a sowie ein zweites wellenlängenselektives optisches Element in Form eines zweiten wellenlängenselektiven Spiegels 13b angeordnet ist (vgl. **Fig. 1b**), die jeweils bei der ersten Wellenlänge $\lambda_1$ des ersten Laserpulses 11a

eine Reflektivität $R_1$ aufweisen, die kleiner ist als die Reflektivität $R_2$ bei der zweiten Wellenlänge $\lambda_2$, d.h. es gilt $R_1 < R_2$. Zur Erzeugung der Differenz zwischen den beiden Reflektivitäten $R_1$, $R_2$ weisen die beiden wellenlängenselektiven Spiegel 13a,b jeweils eine wellenlängenselektive Beschichtung 14a, 14b auf. Im gezeigten Beispiel beträgt die Differenz zwischen der Reflektivität $R_1$ bei der ersten Wellenlänge $\lambda_1$ und der Reflektivität $R_2$ bei der zweiten Wellenlänge $\lambda_2$ an einem jeweiligen wellenlängenselektiven Spiegel 13a, 13b bei mehr als 10 %. Entsprechend wird der erste Laserpuls 11a an den beiden wellenlängenselektiven Spiegeln 13a,b um insgesamt 20 % stärker abgeschwächt als der zweite Laserpuls 11b, wodurch die Gesamt-Verstärkung der Verstärkeranordnung 3 für den ersten Laserpuls 11a entsprechend abnimmt.

Im gezeigten Beispiel weist der jeweilige wellenlängenselektive Spiegel 13a, 13b bei der ersten Wellenlänge $\lambda_1$ eine Reflektivität $R_1$ von weniger als 90 % auf, während die Reflektivität $R_2$ bei der zweiten Wellenlänge $\lambda_2$ bei ca. 98 % liegt, was der maximalen technisch realisierbaren bzw. gewünschten Reflektivität $R_2$ bei der zweiten Wellenlänge $\lambda_2$ entspricht.

Wie in Fig. 1a zu erkennen ist, ist der erste wellenlängenselektive Spiegel 13a ein Umlenkspiegel, der im Strahlengang hinter dem zweiten optischen Verstärker 4b angeordnet ist, um die Laserpulse 11a, 11b zum dritten optischen Verstärker 4c umzulenken. Ein herkömmlicher, nicht wellenlängenselektiver Spiegel 16 dient zur Umlenkung der vom ersten optischen Verstärker 4a ausgehenden Laserpulse 11a, 11b zum zweiten optischen Verstärker 4b.

**Fig. 1b** zeigt den zweiten optischen Verstärker 4b, in dem der zweite wellenlängenselektive Spiegel 13b angeordnet ist, in einer Detaildarstellung. Der zweite optische Verstärker 4b weist eine Eintrittsfenster 15a sowie ein Austrittsfenster 15b auf, die als planparallele Platten ausgebildet sind und durch welche die Laserpulse 11a, 11b in den zweiten optischen Verstärker 4b eintreten bzw. aus dem zweiten optischen Verstärker 4b austreten. Der zweite wellenlängenselektive Spiegel 13b bildet einen ersten Umlenkspiegel des zweiten optischen Verstärkers 4b und dient zur Umlenkung der beiden Laserpulse 11a, 11b auf einen nicht wellenlängenselektiven zweiten Umlenkspiegel 17, der in dem zweiten optischen Verstärker 4b angeordnet ist. In dem zweiten optischen Verstärker 4b ist im gezeigten Beispiel ein gasförmiges Verstärkermedium, typischer Weise in Form von $CO_2$-Gas, eingebracht. Es versteht sich, dass ggf. auch der weitere Umlenkspiegel 17 als wellenlängenselektives optisches Element ausgebildet sein kann, welches für die erste Wellenlänge $\lambda_1$ eine geringere Reflektivität $R_1$ aufweist als für die zweite Wellenlänge $\lambda_2$, um die Abschwächung des ersten Laserpulses 11a zu verstärken. Durch die Verwendung von zwei oder mehr wellenlängenselektiven optischen Elementen 13a, 13b, die an unterschiedlichen Orten in der Verstärkeranordnung 3 angeordnet sind, kann die Gesamt-Verstärkung optimiert werden bzw. es können die Effekte der beiden wellenlängenselektiven optischen Elemente 13a, 13b ausbalanciert werden, wenn einzelne der optischen Verstärker 4a-c in der Sättigung betrieben werden (s.u.). Auf diese Weise kann eine Feinjustage der Verstärkeranordnung 3 vorgenommen werden. Die Verwendung von zwei oder mehr wellenlängenselektiven optischen Elementen 13a, 13b an Stelle eines einzigen wellenlängenselektiven optischen Elements ist auch für den Fall günstig, dass fertigungsbedingt der Unterschied zwischen den Reflektivitäten $R_1$, $R_2$ einer einzelnen wellenlängenselektiven Beschichtung für die beiden unterschiedlichen Wellenlängen $\lambda_1$, $\lambda_2$ nicht ausreichend groß gewählt werden kann.

Um trotz der Abschwächung des ersten Laserpulses 11a durch die wellenlängenselektiven Spiegel 13a,b beim Auftreffen auf das Target-Material 8 die geforderte Leistung des ersten Laserpulses 11a abrufen zu können, wird die Leistung der ersten Laserquelle 2a geeignet angepasst. Die (geringere) Leistung, mit welcher der erste Laserpuls 11a der ersten Laserquelle 2a ohne die Abschwächung durch die wellenlängenselektiven optischen Elemente 13a,b erzeugt würde, ist in Fig. 1a innerhalb des ersten Laserpulses 11a gestrichelt angedeutet.

Fig. 2 zeigt ein Beispiel einer EUV-Strahlungserzeugungsvorrichtung 1, bei der an Stelle eines reflektierenden wellenlängenselektiven optischen Elements ein transmissives wellenlängenselektives optisches Element 13c in Form einer Planplatte, welche eine wellenlängenselektive Beschichtung 14c aufweist, im Strahlengang zwischen dem ersten optischen Verstärker 4a und dem zweiten optischen Verstärker 4b angeordnet ist. Während das Material der Planplatte, die als Trägerelement für die wellenlängenselektive Beschichtung 14c dient, beide Wellenlängen $\lambda_1$, $\lambda_2$ gleich stark transmittiert, wird durch die wellenlängenselektive Beschichtung 14c bei der ersten Wellenlänge $\lambda_1$ eine Transmission $T_1$ erzeugt, die kleiner ist als die Transmission $T_2$ der wellenlängenselektiven Beschichtung 14c bei der zweiten Wellenlänge $\lambda_2$. Auf diese Weise wird analog zu dem weiter oben in Zusammenhang mit Fig. 1a,b beschriebenen Beispiel die Verstärkung des ersten Laserpulses 11a gegenüber der Verstärkung des zweiten Laserpulses 11b in der Verstärkeranordnung 3 abgeschwächt. An Stelle des transmissiven optischen Elements 13c, welches im Strahlengang zwischen dem ersten optischen Verstärker 4a und dem zweiten optischen Verstärker 4b angeordnet ist, kann ggf. auch ein Eintrittsfenster und/oder ein Austrittsfenster eines jeweiligen optischen Verstärkers 4a-c als transmissives wellenlängenselektives optisches Element dienen, beispielsweise das in Fig. 1b gezeigte Eintrittsfenster 15a bzw. das in Fig. 1b gezeigte Austrittsfenster 15b des zweiten optischen Verstärkers 4b.

Wie weiter oben beschrieben wurde, soll durch die Abschwächung des ersten Laserpulses 11a die Verstärkung eines an dem Target-Material 8 rückreflektierten Laserpulses 11a' reduziert werden. Geht man davon aus, dass die Verstärkung des ersten Laserpulses 11a in der Verstärkeranordnung 3 linear erfolgt, d.h. unabhängig vom Absolutwert der Laserleistung ist, ist die Verstärkung für den in einer ersten Propagationsrichtung P1 (Vorwärtsrichtung) von der Strahlquelle 2 aus propagierenden Laserpuls 11a und die Verstärkung für den in einer zweiten, der ersten entgegen gesetzten Propagationsrichtung P2 propagierenden ersten Laserpuls 11a' gleich groß.

Es ist günstig, wenn die Verstärkeranordnung 3 den ersten Laserpuls 11a bei der Propagation durch die Verstärkeranordnung 3 in der ersten Propagationsrichtung P1 mit einer größeren leistungsabhängigen Verstärkung $V_{P1}$ verstärkt als den zurücklaufenden Laserpuls 11a' in der zweiten, der ersten entgegen gesetzten Propagationsrichtung P2, d.h. wenn die Verstärkung $V_{P1}$, $V_{P2}$ der Verstärkeranordnung 3 von der Propagationsrichtung P1, P2 abhängig ist. Eine solche von der Propagationsrichtung P1, P2 abhängige Verstärkung kann realisiert werden, wenn mindestens einer, z.B. der zweite optische Verstärker 4b, im Sättigungsbetrieb arbeitet, d.h. die in den zweiten optischen Verstärker 4b eingekoppelte Laserleistung $p_{IN}$ größer ist als ein Leistungs-Schwellwert $p_{MAX}$, bei dem bzw. unterhalb dessen der zweite Verstärker 4b die eingekoppelte Laserleistung mit seiner maximalen (linearen) Verstärkung $V_{MAX}$ verstärkt.

Ist wie bei dem in Fig. 2 gezeigten Beispiel das wellenlängenselektive optische Element 13a in der ersten Propagationsrichtung P1 vor dem zweiten optischen Verstärker 4b angeordnet und liegt die in den zweiten optischen Verstärker 4b eingekoppelte Leistung $p_{IN}$ über dem Schwellwert $p_{MAX}$, wirkt sich die Abschwächung der Leistung in der ersten Propagationsrichtung P1 weniger stark aus als in der zweiten Propagationsrichtung P2, sofern der erste optische Verstärker 4a nicht ebenfalls im Sättigungsbetrieb betrieben wird. In der Regel ist der Absolutwert der Leistung des rückreflektierten Laserpulses 11a' so gering, dass alle drei optischen Verstärker 4a-c für die zweite Propagationsrichtung P2 nicht im Sättigungsbetrieb arbeiten, d.h. die in der zweiten Propagationsrichtung P2 eingekoppelte Leistung liegt jeweils unterhalb des Schwellwerts $p_{MAX}$. Die Verstärkung $V_{P1}$ der Verstärkeranordnung 3 für den ersten Laserpuls 11a in der ersten Propagationsrichtung P1 ist daher größer als die Verstärkung $V_{P2}$ für den reflektierten ersten Laserpuls 11a' in der zweiten Propagationsrichtung P2.

Es versteht sich, dass das wellenlängenselektive (transmissive oder reflektierende) optische Element 13, 13a auch an anderer Stelle im Strahlengang der Verstärkeranordnung 3 angeordnet sein kann, beispielsweise vor dem ersten optischen Verstärker 4a oder (direkt) nach dem dritten optischen Verstärker 4c, oder an anderer Stelle zwischen den optischen Verstärkern 4a-c. Auch kann ein transmissives wellenlängenselektives optisches Element 13a in einem optischen Verstärker 4a-c angeordnet werden. Auch wenn weiter oben Laserquellen 2a, 2b in Form von $CO_2$-Lasern beschrieben sind, können selbstverständlich auch Laserquellen verwendet werden, die andere erste bzw. zweite Wellenlängen $\lambda_1$, $\lambda_2$ erzeugen, wobei diese insbesondere um mehr als 0,5 $\mu$m voneinander abweichen können.

Zusätzlich zu den weiter oben beschriebenen wellenlängenselektiven optischen Elementen 13a-c kann die Treiberlaseranordnung 12 auch eine Frequenzverschiebungseinrichtung aufweisen, um die Laserfrequenz bzw. die Laserwellenlänge $\lambda_1$, $\lambda_2$ einzustellen bzw. zu verändern. Die Frequenzverschiebungseinrichtung kann beispielsweise als akusto-optischer Modulator ausgebildet sein. Da die Verstärkung der einzelnen Verstärker 4a-c und damit die Gesamt-Verstärkung der Verstärkeranordnung 3 wellenlängenabhängig ist, führt die Veränderung der Laserwellenlänge $\lambda_1$, $\lambda_2$ zu einer Änderung der Verstärkung der jeweiligen Laserpulse 11a, 11b in den einzelnen optischen Verstärkern 4a-c. Die Einstellung der Verstärkung mit Hilfe einer Frequenzverschiebungseinrichtung ist auch während des Betriebs der EUV-Strahlungserzeugungseinrichtung 1 möglich, so dass eine Feinabstimmung der Gesamt-Verstärkung der Verstärkeranordnung 3 im Betrieb vorgenommen werden kann.

Zusammenfassend kann auf die oben beschriebene Weise vorteilhaft eine Reduzierung der Verstärkung des ersten Laserpulses 11a durch die Verstärkeranordnung 3 gegenüber der Verstärkung der Laserleistung des zweiten Laserpulses 11b durch die Verstärkeranordnung 3 vorgenommen werden. Hierbei kann insbesondere die Verstärkung eines an dem Target-Material 8 rückreflektierten ersten Laserpulses 11a' bei der Propagation zurück durch die Verstärkeranordnung 3 wirksam abgeschwächt werden. Es versteht sich, dass ein wellenlängenselektives optisches Element, welches den ersten Laserpuls 11a stärker unterdrückt als den zweiten Laserpuls 11b auch an anderer Stelle im gemeinsamen Strahlengang der beiden Laserpulse 11a, 11b in der EUV-Strahlungserzeugungsvorrichtung 1 angeordnet werden kann, beispielsweise in der Strahlführungseinrichtung 5.

**Patentansprüche**

1. Treiberlaseranordnung (12) für eine EUV-Strahlungserzeugungsvorrichtung (1), umfassend:

   eine Strahlquelle (2), die ausgebildet ist, einen ersten Laserpuls (11a) mit einer ersten Wellenlänge ($\lambda_1$) und einen zweiten, zeitlich nachfolgenden Laserpuls (11b) mit einer zweiten Wellenlänge ($\lambda_2$) zu erzeugen, sowie eine Verstärkeranordnung (3) mit mindestens einem optischen Verstärker (4a-c) zur Verstärkung des ersten Laserpulses (11a) und des zweiten Laserpulses (11b),
   eine Überlagerungseinrichtung zum Zusammenführen der Strahlwege der beiden Laserpulse (11a, 11b) vor der Verstärkeranordnung (3), so dass die beiden Laserpulse (11a, 11b) die Verstärkeranordnung (3) im gleichen Strahlengang durchlaufen,

**dadurch gekennzeichnet,**

**dass** die Verstärkeranordnung (3) mindestens ein im gemeinsamen Strahlengang der Laserpulse (11a, 11b) nach der Überlagerungseinrichtung angeordnetes wellenlängenselektives optisches Element (13a, 13b, 13c) aufweist, das ausgebildet ist, den ersten Laserpuls (11a) bei der ersten Wellenlänge ($\lambda_1$) stärker abzuschwächen als den zweiten Laserpuls (11b) bei der zweiten Wellenlänge ($\lambda_2$).

2. Treiberlaseranordnung nach Anspruch 1, bei der die Abschwächung des ersten Laserpulses (11a) bei der ersten Wellenlänge ($\lambda_1$) durch das mindestens eine wellenlängenselektive optische Element (13a, 13b, 13c) bei der Propagation durch die Verstärkeranordnung (3) um mehr als 10 % größer ist als die Abschwächung des zweiten Laserpulses (11b) bei der zweiten Wellenlänge ($\lambda_2$) bei der Propagation durch die Verstärkeranordnung (3).

3. Treiberlaseranordnung nach Anspruch 1 oder 2, bei der das wellenlängenselektive optische Element ein reflektierendes optisches Element (13a, 13b) ist, dessen Reflektivität ($R_1$) bei der ersten Wellenlänge ($\lambda_1$) kleiner ist als dessen Reflektivität ($R_2$) bei der zweiten Wellenlänge ($\lambda_2$).

4. Treiberlaseranordnung nach Anspruch 3, bei der das wellenlängenselektive reflektive optische Element ein Umlenkspiegel (13a, 13b) der Verstärkeranordnung (3) ist.

5. Treiberlaseranordnung nach einem der Ansprüche 3 oder 4, bei der das wellenlängenselektive reflektive optische Element (13) bei der ersten Wellenlänge ($\lambda_1$) eine Reflektivität ($R_1$) von weniger als 90 % aufweist.

6. Treiberlaseranordnung nach Anspruch 1 oder 2, bei der das wellenlängenselektive optische Element ein transmissives optisches Element (13c) ist, dessen Transmission ($T_1$) bei der ersten Wellenlänge ($\lambda_2$) kleiner ist als dessen Transmission ($T_2$) bei der zweiten Wellenlänge ($\lambda_1$).

7. Treiberlaseranordnung nach einem der vorhergehenden Ansprüche, bei welcher das wellenlängenselektive optische Element (13, 13a) eine wellenlängenselektive Beschichtung (14a, 14b) aufweist.

8. Treiberlaseranordnung nach einem der vorhergehenden Ansprüche, bei welcher die Strahlquelle (2) ausgebildet ist, den ersten Laserpuls (11a) bei einer ersten Wellenlänge ($\lambda_1$) zu erzeugen, die um 0,5 $\mu$m oder weniger von der zweiten Wellenlänge ($\lambda_2$) des zweiten Laserpulses (11b) abweicht.

9. Treiberlaseranordnung nach einem der vorhergehenden Ansprüche, welche ausgebildet ist, den ersten Laserpuls (11a) mit der ersten Wellenlänge ($\lambda_1$) bei der Propagation durch die Verstärkeranordnung (3) in einer ersten Propagationsrichtung (P1), die von der Strahlquelle (2) ausgeht, mit einer größeren leistungsabhängigen Verstärkung ($V_{P1}$) zu verstärken als in einer zweiten, der ersten entgegen gesetzten Propagationsrichtung (P2).

10. Treiberlaseranordnung nach einem der vorhergehenden Ansprüche, bei welcher das wellenlängenselektive optische Element (13b) in der ersten Propagationsrichtung (P1) vor oder in mindestens einem optischen Verstärker (4b) angeordnet ist, welcher den ersten Laserpuls (11a) mit einer kleineren als einer maximalen leistungsabhängigen Verstärkung ($V_{MAX}$) verstärkt.

11. EUV-Strahlungserzeugungsvorrichtung (1), umfassend:

    eine Treiberlaseranordnung (12), umfassend:

    eine Strahlquelle (2), die ausgebildet ist, einen ersten Laserpuls (11a) mit einer ersten Wellenlänge ($\lambda_1$) und einen zweiten, zeitlich nachfolgenden Laserpuls (11b) mit einer zweiten Wellenlänge ($\lambda_2$) zu erzeugen,

    eine Verstärkeranordnung (3) mit mindestens einem optischen Verstärker (4a-c) zur Verstärkung des ersten Laserpulses (11a) und des zweiten Laserpulses (11b), sowie

    eine Überlagerungseinrichtung zum Zusammenführen der Strahlwege der beiden Laserpulse (11a, 11b) vor der Verstärkeranordnung (3), so dass die beiden Laserpulse (11a, 11b) die Verstärkeranordnung (3) im gleichen Strahlengang durchlaufen,

    eine Vakuum-Kammer (10), in der ein Target-Material (8) an einer Zielposition (T) anordenbar ist, sowie

    eine Strahlführungseinrichtung (5) zur Führung des ersten Laserpulses (11a) und des zweiten Laserpulses (11b) von der Treiberlaseranordnung (12) in Richtung auf die Zielposition (T),

    **dadurch gekennzeichnet,**

    **dass** die Verstärkeranordnung (3) oder die Strahlführungseinrichtung (5) mindestens ein im gemeinsamen Strahlengang der Laserpulse (11a, 11b) nach der Überlagerungseinrichtung angeordnetes wellenlängenselektives optisches Element (13a, 13b, 13c) aufweist, das ausgebildet ist, den ersten Laserpuls (11a) bei

der ersten Wellenlänge ($\lambda_1$) stärker abzuschwächen als den zweiten Laserpuls (11b) bei der zweiten Wellenlänge ($\lambda_2$).

12. Verfahren zum Verstärken eines ersten Laserpulses (11a) mit einer ersten Wellenlänge ($\lambda_1$) und eines zweiten Laserpulses (11b) mit einer zweiten Wellenlänge ($\lambda_2$) in einer Treiberlaseranordnung (12) für eine EUV-Strahlungserzeugungsvorrichtung (1), umfassend:
Verstärken des ersten Laserpulses (11a) und des zweiten, zeitlich nachfolgenden Laserpulses (11b) in mindestens einem optischen Verstärker (4a-c) einer Verstärkeranordnung (3) der Treiberlaseranordnung (12), wobei die Strahlwege der beiden Laserpulse (11a, 11b) in einer Überlagerungseinrichtung vor der Verstärkeranordnung (3) zusammengeführt werden, so dass die beiden Laserpulse (11a, 11b) die Verstärkeranordnung (3) im gleichen Strahlengang durchlaufen, und wobei der erste Laserpuls (11a) an mindestens einem im gemeinsamen Strahlengang der Laserpulse (11a, 11b) nach der Überlagerungseinrichtung angeordneten wellenlängenselektiven optischen Element (13, 13a) der Verstärkeranordnung (3) stärker abgeschwächt wird als der zweite Laserpuls (11b).

13. Verfahren nach Anspruch 12, bei dem der erste Laserpuls (11a) bei der ersten Wellenlänge ($\lambda_1$) an dem mindestens einen wellenlängenselektiven optischen Element (13a-c) um mehr als 10 % stärker abgeschwächt wird als der zweite Laserpuls (11b) bei der zweiten Wellenlänge ($\lambda_2$).

14. Verfahren nach Anspruch 12 oder 13, bei dem der erste Laserpuls (11a) mit der ersten Wellenlänge ($\lambda_1$) bei der Propagation durch die Verstärkeranordnung (3) in einer ersten Propagationsrichtung (P1), die von einer Strahlquelle (2) der Verstärkeranordnung (3) ausgeht, mit einer größeren leistungsabhängigen Verstärkung ($V_{P1}$) verstärkt wird als in einer zweiten, der ersten entgegen gesetzten Propagationsrichtung (P2).

**Claims**

1. A driver laser assembly (12) for an EUV radiation generating device (1), comprising:

a radiation source (2), which is designed to generate a first laser pulse (11a) having a first wavelength ($\lambda_1$) and a second, temporally subsequent laser pulse (11b) having a second wavelength ($\lambda_2$), and
an amplifier assembly (3) having at least one optical amplifier (4a-c) for amplifying the first laser pulse (11a) and the second laser pulse (11b),
a superposition unit for superimposing the beam paths of the two laser pulses (11a, 11b) upstream of the amplifier assembly (3), so that the two laser pulses (11a, 11b) pass the amplifier assembly (3) along a common beam path,
**characterized in that**
the amplifier assembly (3) has at least one wavelength-selective optical element (13a, 13b, 13c) arranged in the common beam path of the laser pulses (11a, 11b) downstream of the superposition unit, which is designed to attenuate the first laser pulse (11a) at the first wavelength ($\lambda_1$) more strongly than the second laser pulse (11b) at the second wavelength ($\lambda_2$).

2. The driver laser assembly as claimed in claim 1, in which the attenuation of the first laser pulse (11a) at the first wavelength ($\lambda_1$) by the at least one wavelength-selective optical element (13a, 13b, 13c) during the propagation through the amplifier assembly (3) is greater by more than 10% than the attenuation of the second laser pulse (11b) at the second wavelength ($\lambda_2$) during the propagation through the amplifier assembly (3).

3. The driver laser assembly as claimed in claim 1 or 2, in which the wavelength-selective optical element is a reflective optical element (13a, 13b), the reflectivity ($R_1$) of which at the first wavelength ($\lambda_1$) is less than the reflectivity ($R_2$) thereof at the second wavelength ($\lambda_2$).

4. The driver laser assembly as claimed in claim 3, in which the wavelength-selective reflective optical element is a deflection mirror (13a, 13b) of the amplifier assembly (3).

5. The driver laser assembly as claimed in any one of claims 3 and 4, in which the wavelength-selective reflective optical element (13) has a reflectivity ($R_1$) of less than 90% at the first wavelength ($\lambda_1$).

6. The driver laser assembly as claimed in claim 1 or 2, in which the wavelength-selective optical element is a transmissive optical element (13c), the transmission ($T_1$) of which at the first wavelength ($\lambda_2$) is less than the transmission ($T_2$) thereof at the second wavelength ($\lambda_1$).

7. The driver laser assembly as claimed in any one of the preceding claims, in which the wavelength-selective optical element (13, 13a) has a wavelength-selective coating (14a, 14b).

8. The driver laser assembly as claimed in any one of the preceding claims, in which the radiation source (2) is designed to generate the first laser pulse (11a) at a first wavelength ($\lambda_1$) which deviates by 0.5 $\mu$m or less from the second wavelength ($\lambda_2$) of the second laser pulse (11b).

9. The driver laser assembly as claimed in any one of the preceding claims, which is designed to amplify the first laser pulse (11a) having the first wavelength ($\lambda_1$) during the propagation through the amplifier assembly (3) in a first propagation direction (P1), which originates from the radiation source (2), using a greater power-dependent amplification ($V_{P_1}$) than in a second propagation direction (P2) opposite to the first.

10. The driver laser assembly as claimed in any one of the preceding claims, in which the wavelength-selective optical element (13b) is arranged in the first propagation direction (P1) before or in at least one optical amplifier (4b), which amplifies the first laser pulse (11a) with less than a maximal power-dependent amplification ($V_{MAX}$).

11. An EUV radiation generating device (1), comprising: a driver laser assembly (12), comprising:

    a radiation source (2), which is designed to generate a first laser pulse (11a) having a first wavelength ($\lambda_1$) and a second laser pulse (11b) having a second wavelength ($\lambda_2$), and
    an amplifier assembly (3) having at least one optical amplifier (4a-c) for amplifying the first laser pulse (11a) and the second laser pulse (11b),
    a superposition unit for superimposing the beam paths of the two laser pulses (11a, 11b) upstream of the amplifier assembly (3), so that the two laser pulses (11a, 11b) pass the amplifier assembly (3) along a common beam path,
    a vacuum chamber (10), in which a target material (8) can be arranged at a target position (T), and
    a beam guiding device (5) for guiding the first laser pulse (11a) and the second laser pulse (11b) from the driver laser assembly (12) in the direction of the target position (T), **characterized in that**
    the amplifier assembly (3) or the beam guiding device (5) has at least one wavelength-selective optical element (13a, 13b, 13c) arranged downstream of the superposition unit in the common beam path of the laser pulses (11a, 11b), which is designed to attenuate the first laser pulse (11a) at the first wavelength ($\lambda_1$) more strongly than the second laser pulse (11b) at the second wavelength ($\lambda_2$).

12. A method for amplifying a first laser pulse (11a) having a first wavelength ($\lambda_1$) and a second laser pulse (11b) having a second wavelength ($\lambda_2$) in a driver laser assembly (12) for an EUV radiation generating device (1), comprising:
    amplifying the first laser pulse (11a) and the second, temporally subsequent laser pulse (11b) in at least one optical amplifier (4a-c) of an amplifier assembly (3) of the driver laser assembly (12), wherein the beam paths of the two laser pulses (11a, 11b) are superimposed in a superposition unit upstream of the amplifier assembly (3), so that the two laser pulses (11a, 11b) pass the amplifier assembly (3) along a common beam path, and wherein the first laser pulse (11a) is attenuated more strongly than the second laser pulse (11b) at at least one wavelength-selective optical element (13, 13a) of the amplifier assembly (3) that is arranged in the common beam path of the laser pulses (11a, 11b) downstream of the superposition unit.

13. The method as claimed in claim 12, in which the first laser pulse (11a) at the first wavelength ($\lambda_1$) is attenuated by more than 10% more strongly at the at least one wavelength-selective optical element (13a-c) than the second laser pulse (11b) at the second wavelength ($\lambda_2$).

14. The method as claimed in claim 12 or 13, in which the first laser pulse (11a) having the first wavelength ($\lambda_1$) is amplified during the propagation through the amplifier assembly (3) in a first propagation direction (P1), which originates from a radiation source (2) of the amplifier assembly (3), with a greater power-dependent amplification ($V_{P_1}$) than in a second propagation direction (P2) opposite to the first.

**Revendications**

1. Arrangement laser excitateur (12) pour un système de génération de rayonnement EUV (1), comprenant :

    une source de rayon (2), qui est configurée pour générer une première impulsion laser (11a) ayant une première longueur d'onde ($\lambda_1$) et une deuxième impulsion laser (11b), chronologiquement suivante, ayant une deuxième longueur d'onde ($\lambda_2$), ainsi
    qu'un arrangement amplificateur (3) comprenant au moins un amplificateur optique (4a-c) destiné à amplifier la première impulsion laser (11a) et la deuxième impulsion laser (11b),
    un dispositif de superposition destiné à fusionner les trajets de rayon des deux impulsions laser (11a, 11b) avant l'arrangement amplificateur (3), de sorte que les deux impulsions laser (11a, 11b) traversent l'arrangement amplificateur (3) dans la même trajectoire de rayon,

**caractérisé en ce**
**que** l'arrangement amplificateur (3) possède au moins un élément optique (13a, 13b, 13c) sélectif en longueur d'onde disposé après le dispositif de superposition dans la trajectoire de rayon commune des impulsions laser (11a, 11b), lequel est configuré pour affaiblir davantage la première impulsion laser (11a) à la première longueur d'onde ($\lambda_1$) que la deuxième impulsion laser (11b) à la deuxième longueur d'onde ($\lambda_2$).

2. Arrangement laser excitateur selon la revendication 1, avec lequel l'affaiblissement de la première impulsion laser (11a) à la première longueur d'onde ($\lambda_1$) par l'au moins un élément optique (13a, 13b, 13c) sélectif en longueur d'onde lors de la propagation à travers l'arrangement amplificateur (3) est supérieur de plus de 10 % à l'affaiblissement de la deuxième impulsion laser (11b) à la deuxième longueur d'onde ($\lambda_2$) lors de la propagation à travers l'arrangement amplificateur (3).

3. Arrangement laser excitateur selon la revendication 1 ou 2, avec lequel l'élément optique sélectif en longueur d'onde est un élément optique (13a, 13b) réfléchissant dont la réflectivité ($R_1$) à la première longueur d'onde ($\lambda_1$) est inférieure à sa réflectivité ($R_2$) à la deuxième longueur d'onde ($\lambda_2$).

4. Arrangement laser excitateur selon la revendication 3, avec lequel l'élément optique sélectif en longueur d'onde est un miroir de déviation (13a, 13b) de l'arrangement amplificateur (3).

5. Arrangement laser excitateur selon l'une des revendications 3 ou 4, avec lequel l'élément optique (13) réfléchissant sélectif en longueur d'onde présente une réflectivité ($R_1$) inférieure à 90 % à la première longueur d'onde ($\lambda_1$).

6. Arrangement laser excitateur selon la revendication 1 ou 2, avec lequel l'élément optique sélectif en longueur d'onde est un élément optique transmissif (13c) dont la transmission ($T_1$) à la première longueur d'onde ($\lambda_1$) est inférieure à sa transmission ($T_2$) à la deuxième longueur d'onde ($\lambda_2$).

7. Arrangement laser excitateur selon l'une des revendications précédentes, avec lequel l'élément optique (13, 13a) sélectif en longueur d'onde possède un revêtement sélectif en longueur d'onde (14a, 14b).

8. Arrangement laser excitateur selon l'une des revendications précédentes, la source de rayon (2) est configurée pour générer la première impulsion laser (11a) à une première longueur d'onde ($\lambda_1$) qui s'écarte de 0,5 $\mu$m ou moins de la deuxième longueur d'onde ($\lambda_2$) de la deuxième impulsion laser (11b).

9. Arrangement laser excitateur selon l'une des revendications précédentes, lequel est configuré pour amplifier la première impulsion laser (11a) ayant la première longueur d'onde ($\lambda_1$), lors de la propagation à travers l'arrangement amplificateur (3) dans une première direction de propagation (P1), qui résulte de la source de rayon (2), avec un gain dépendant de la puissance ($V_{P1}$) plus élevé que dans une deuxième direction de propagation (P2) opposée à la première.

10. Arrangement laser excitateur selon l'une des revendications précédentes, avec lequel l'élément optique (13b) sélectif en longueur d'onde, dans la première direction de propagation (P1), est disposé avant ou dans au moins un amplificateur optique (4b), lequel amplifie la première impulsion laser (11a) avec un gain dépendant de la puissance plus petit qu'un gain dépendant de la puissance maximal ($V_{MAX}$).

11. Système de génération de rayonnement EUV (1), comprenant :
un arrangement laser excitateur (12), comprenant :

une source de rayon (2), qui est configurée pour générer une première impulsion laser (11a) ayant une première longueur d'onde ($\lambda_1$) et une deuxième impulsion laser (11b), chronologiquement suivante, ayant une deuxième longueur d'onde ($\lambda_2$),
un arrangement amplificateur (3) comprenant au moins un amplificateur optique (4a-c) destiné à amplifier la première impulsion laser (11a) et la deuxième impulsion laser (11b),
un dispositif de superposition destiné à fusionner les trajets de rayon des deux impulsions laser (11a, 11b) avant l'arrangement amplificateur (3), de sorte que les deux impulsions laser (11a, 11b) traversent l'arrangement amplificateur (3) dans la même trajectoire de rayon,
une chambre à vide (10), dans laquelle un matériau cible (8) peut être disposé à une position cible (T), et
un dispositif de guidage de rayon (5) destiné à guider la première impulsion laser (11a) et la deuxième impulsion laser (11b) de l'arrangement laser excitateur (12) en direction de la position cible (T),
**caractérisé en ce**
**que** l'arrangement amplificateur (3) ou le dispositif de guidage de rayon (5) possède au moins un élément optique (13a, 13b, 13c) sélectif en longueur d'onde disposé après le dispositif de superposition dans la trajectoire de rayon commune des impulsions laser (11a, 11b), lequel est configuré pour affaiblir davantage la première impulsion laser (11a) à la première longueur d'onde ($\lambda_1$) que la deuxième impulsion laser (11b) à la deuxième longueur d'onde ($\lambda_2$).

12. Procédé pour amplifier une première impulsion laser (11a) ayant une première longueur d'onde ($\lambda_1$) et une deuxième impulsion laser (11b) ayant une deuxième longueur d'onde ($\lambda_2$) dans un arrangement laser excitateur (12) pour un système de génération de rayonnement EUV (1), comprenant : amplification de la première impulsion laser (11a) et de la deuxième impulsion laser (11b), chronologiquement suivante, dans au moins un amplificateur optique (4a-c) d'un arrangement amplificateur (3) de l'arrangement laser excitateur (12), les trajets de rayon des deux impulsions laser (11a, 11b) étant fusionnés dans un dispositif de superposition avant l'arrangement amplificateur (3), de sorte que les deux impulsions laser (11a, 11b) traversent l'arrangement amplificateur (3) dans la même trajectoire de rayon, et la première impulsion laser (11a) étant plus fortement affaiblie que la deuxième impulsion laser (11b) au niveau d'au moins un élément optique (13, 13a) sélectif en longueur d'onde de l'arrangement amplificateur (3), disposé après le dispositif de superposition dans la trajectoire de rayon commune des impulsions laser (11a, 11b).

13. Procédé selon la revendication 12, avec lequel la première impulsion laser (11a) à la première longueur d'onde ($\lambda_1$) est affaiblie plus fortement de plus de 10 % au niveau de l'au moins un élément optique (13a-c) sélectif en longueur d'onde que la deuxième impulsion laser (11b) à la deuxième longueur d'onde ($\lambda_2$).

14. Procédé selon la revendication 12 ou 13, avec lequel la première impulsion laser (11a) à la première longueur d'onde ($\lambda_1$), lors de la propagation à travers l'arrangement amplificateur (3) dans une première direction de propagation (P1), qui résulte d'une source de rayon (2) de l'arrangement amplificateur (3), est amplifiée avec un gain dépendant de la puissance ($V_{P1}$) plus élevé que dans une deuxième direction de propagation (P2) opposée à la première.

Fig. 1a

Fig. 1b

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2008149862 A1
- US 20060192152 A1
- US 20090095925 A1
- WO 2011162903 A1
- DE 4127407 A1
- EP 0674375 A2
- EP 2014064958 W